# EUROPÄISCHE PATENTSCHRIFT

(11) **EP 0 637 129 B1**
(45) Veröffentlichungstag und Bekanntmachung des Hinweises auf die Patenterteilung: **23.09.1998**
(21) Anmeldenummer: 94110546.2
(22) Anmeldetag: 07.07.1994
(51) Int. Cl.: H03G 3/20, H03G 3/00, H03G 3/30, H04B 3/12

(54) **Automatische Amplitudenregelung für einen Breitbandsender**
Automatic amplitude control for a broad band transmitter
Contrôle automatique de l'amplitude dans un émetteur à large bande

(30) Priorität: 26.07.1993 DE 4325020
(43) Veröffentlichungstag der Anmeldung: 01.02.1995
(73) Patentinhaber: ALCATEL ALSTHOM COMPAGNIE GENERALE D'ELECTRICITE, 75008 Paris (FR)
(72) Erfinder: Steigenberger Ulrich, D-70565 Stuttgart (DE); Braun, Klaus, D-72127 Kusterdingen (DE)
(74) Vertreter: Schätzle, Albin, Dipl.-Phys.

(56) Entgegenhaltungen:
- EP-A- 0 432 399
- DE-B- 2 751 596
- GB-A- 2 238 435
- US-A- 3 737 774

## Beschreibung

Die Erfindung betrifft eine automatische Amplitudenregelung für einen Breitbandsender eines Fernsehverteilsystems gemäß dem Oberbegriff von Anspruch 1.

Solche Breitbandsender sind bereits aus bestehenden optischen Fernsehverteilsystemen bekannt. Anwendung finden solche Breitbandsender dabei, z.B. in übergeordneten Verstärkerstellen, in denen verschiedene Rundfunk- und Fernsehkanäle von verschiedenen Zubringern herkommend zusammengefaßt und aufbereitet werden. Zubringern können z.B. überregionale Weitverkehrs-, Koaxial- oder GF-Systeme, sowie regionale Rundfunk- oder Fernsehsender, oder auch terrestrische Sender sein. Die zusammengefaßten Kanäle werden z.B. in ein optisches oder koaxiales Kabelfernsehverteilnetz als kombiniertes Breitbandsignal eingespeist. Durch die Vielzahl der von den verschiedenen Signalquellen kommenden Fernseh- und Rundfunkkanäle sind in dem kombinierten Summensignal, das von der Verstärkerstelle ausgesendet wird, Pegelschwankungen unvermeidlich. Ebenso kann sich von Verstärkerstelle zur Verstärkerstelle oder im Laufe der Zeit in einer bestimmten Verstärkerstelle die Anzahl der übertragenen Kanäle ändern.

Bei einem Fernsehverteilsystem wird jedoch an seinem elektrischen Eingang ein jeweils konstanter Kanalpegel erwartet, dabei ist die maximale Aussteuerbarkeit eines Kanals näherungsweise durch das Produkt der Wurzel der Anzahl der Kanäle mit dem jeweiligen Kanalpegel begrenzt. D.h. die Fernsehkanäle lassen sich bei Vorliegen einer geringen Anzahl von Kanälen höher aussteuern und können somit mit einer besseren Übertragungsqualität übertragen werden als wenn schon eine hohe Anzahl von Kanälen übertragen werden soll. Um eine Übertragung mit stets hoher Qualität zu gewährleisten ist eine die Anzahl der Fernseh- und Rundfunkkanäle berücksichtigende Regelschaltung in Form einer Summenlastregelung vorgesehen. Diese Summenlastregelung hält den Gesamtmodulationsgrad konstant, d.h. sie ist in der Lage den Breitbandsender immer optimal anzusteuern.

Bei einer Vielzahl von Kabelfernsehverteilsystemen werden die Empfänger am Ausgang des Kabelfernsehteilssystems mit einem im Empfangssignal enthaltenen Pilotsignal amplitudengeregelt. Dieses Pilotsignal wird üblicherweise zum Beispiel im bestehenden optischen Fernsehverteilsystem der Deutschen Bundespost Telekom bei einer Trägerwellenlänge λ= 1300 nm im Sender des Systems eingespeist. Bei dem bekannten System erfolgt die Einspeisung des Pilotsignals nach Vereinigung der verschiedenen Rundfunk- und Fernsehkanäle im Sender und zwar vor dessen Summenlastregelung.

Dies hat grundsätzlich zur Folge, daß das eine Pilotsignal im Falle eines optischen Senders, oder die Pilotsignale im Falle eines elektrischen Senders in keiner festen Beziehung zu der Anzahl der Fernsehkanäle und zu deren jeweiligen Kanalpegel steht oder stehen. Die Pilotsignale können somit nur zuverlässig zur Kompensation von übertragungsstreckenabhängigen Dämpfungen aber nicht zur optimalen Aussteuerung der Kanäle im Empfänger herangezogen werden. Ist z.B. am Eingang des Fernsehverteilsystems der Pegel des Übertragungssignals zu hoch, so ist der Sender zwar durch die Summenlastregelung vor einer Übersteuerung geschützt, der Empfänger jedoch kann in Übersteuerung gebracht werden. Auf der anderen Seite führen zu kleine Kanalpegel im Sender zu einem zu kleinen Ausgangspegel im Empfänger, was eine schlechte Bildqualität zu Folge hat.

Ein Breitband-Übertragungssystem mit Pilotsignal-Regelung ist aus EP-A-0 432 399 bekannt.

Der Erfindung liegt daher die Aufgabe zugrunde, eine automatische Amplitudenregelung eines Breitbandsenders für ein Fernsehverteilsystem zur Übertragung einer Vielzahl von Übertragungskanälen zu schaffen, bei dem die Anzahl der Übertragungskanäle variierbar ist, die Kanäle unterschiedliche Pegel aufweisen können, und bei dem im Fernsehverteilsystem die Empfänger bei einem konstanten Gesamtmodulationsgrad über ein Pilotsignal amplitudengeregelt sind.

Die Aufgabe wird durch die Lehre des Anspruchs 1 gelöst.

Vorteilhafte Ausgestaltungen sind den abhängigen Ansprüchen zu entnehmen.

Die Erfindung wird zum besseren Verständnis im folgenden anhand der Figuren auch erläutert. Es zeigen:
- Fig. 1: die schematische Darstellung eines Kabelfernsehverteilsystems,
- Fig. 2: die schematische Darstellung eines Breitbandsenders eines optischen Kabelfernsehverteilsystems,
- Fig. 3: ein erstes Ausführungsbeispiel einer automatischen Amplitudenregelung für einen Sender eines optischen Kabelfernsehverteilsystem, und
- Fig. 4: ein zweites Ausführungsbeispiel einer automatischen Amplitudenregelung für einen Sender eines Kabelfernsehverteilsystems.

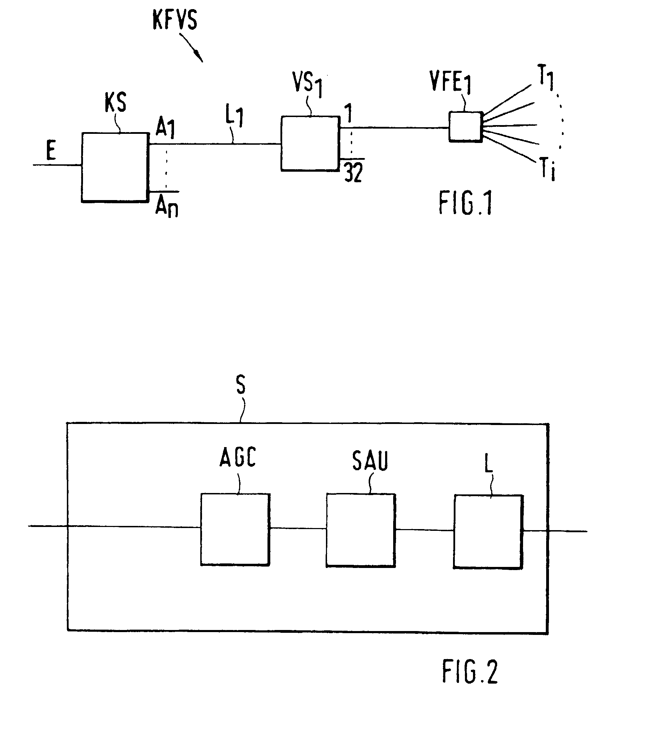

In Fig. 1 ist ein optisches Kabelfernsehverteilsystem KFVS repräsentativ für auch andere Fernsehverteilsysteme mit anderen Übertragungsmedien schematisch abgebildet. Das Kabelfernsehverteilsystem KFVS zeigt eine Kopfstation KS mit einem Eingang E und mit Ausgängen A₁-Aₙ. Über den Eingang E werden die verschiedenen Rundfunk- und Fernsehkanäle einzeln oder in Gruppen zugeführt, zu einem zu verteilenden Übertragungssignal zusammengefaßt und jeweils über die Ausgänge A₁-Aₙ der Kopfstation KS weitergeleitet. In Fig. 1 ist beispielhaft nur eine Leitung L₁ abgebildet, über die das Übertragungssignal auf eine Verteilstation VS geführt ist und dort auf z.B. 32 verschiedene Vorfeldeinrichtungen VFE oder direkt in einzelne Gebäude verteilt wird. In der Fig. 1 ist repräsentativ für auch andere Vorfeldeinrichtungen die Vorfeldeinrichtung VFE₁ abgebildet. Sie ist letztlich mit den Teilnehmern T₁-Tᵢ verbunden.

Die Erfindung betrifft die automatische Amplitudenregelung AGC eines Senders S der in der Kopfstation KS angeordnet ist. Dem Sender S wird ein die verschiedenen Rundfunk- und Fernsehkanäle enthaltendes Signal zu geführt. In der automatischen Amplitudenregelung AGC wird dieses Signal mit einem Pilotsignal versehen und über eine weitere Signalaufbereitung SAU als Modulationssignal einem Laser L zugeführt. In der Signalaufbereitung SAU werden noch weitere dem Fachmann bekannte übliche Maßnahmen, wie Klirrkompensation, Vorverzerrung und dgl. durchgeführt.

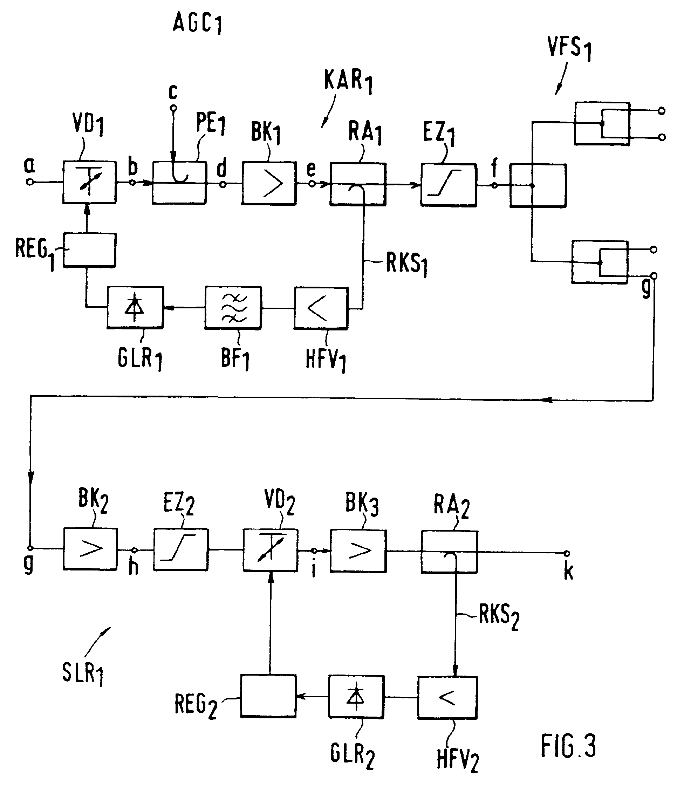

Ein erstes Ausführungsbeispiel einer erfindungsgemäßen automatischen Amplitudenregelung AGC₁ ist in Fig. 3 abgebildet. Die Amplitudenregelung AGC₁ besteht aus einer Kanalamplitudenregelung KAR₁ und einer Summenlastregelung SLR₁, die in Reihe angeordnet sind. Die Kanalamplitudenregelung KAR₁ weist als Eingangselement für das zusammengesetzte Übertragungssignal ein erstes variables Dämpfungsglied VD₁ auf, das über eine Rückkoppelschleife RKS₁ geregelt wird. Dem variablen Dämpfungsglied VD₁ ist zunächst eine Einkoppelvorrichtung PE₁ für ein Pilotsignal, danach ein Breitbandverstärker BK₁, eine Auskoppelvorrichtung RA₁ für die Rückkoppelschleife RKS₁ und einen Entzerrer EZ₁ nachgeschaltet. Die Rückkoppelschleife RKS₁ zeigt zunächst einen Hochfrequenzverstärker HFV₁, ein diesem nachgeschalteten Bandpaßfilter BF₁, das auf einen Gleichrichter GLR₁ geführt ist. Der Gleichrichter GLR₁ ist auf den Regler REG₁ geführt, der dann das Regelsignal für das variable Dämpfungsglied VD₁ liefert. Der Ausgang des Entzerrers EZ₁ stellt gleichzeitig den Ausgang der Kanalamplitudenregelung KAR₁ dar und ist über ein Vierfach-Splitter VFS₁ mit dem Eingangsglied der Summenlastregelung SLR₁, nämlich einem Breitbandverstärker BK₂, verbunden. Der Breitbandverstärker BK₂ ist über einen Entzerrer EZ₂, ein zweites variables Dämpfungsglied VD₂, einen weiteren Breitbandverstärker BK₃ und einer Auskoppelvorrichtung RA₂ für eine breitbandige Rückkoppelschleife RKS₂ mit dem Ausgang der Summenlastregelung SLR₁, der gleichzeitig auch den Ausgang der Amplitudenregelung AGC₁ darstellt verbunden. Die Rückkoppelschleife RKS₂ weist einen Hochfrequenzverstärker HFV₂, einen nachgeschalteten Gleichrichter GLR₂ und einen als Differenzverstärker ausgebildeten Regler REG₂ auf. Der Regler REG₂ liefert das Regelsignal für das variable Dämpfungsglied VD₂.

Zum besseren Verständnis der Erfindung wird die Funktionsweise anhand einiger beispielhafter Zahlenwerte erläutert. Als Meßpunkte für die jeweiligen Amplitudenwerte sind in der Fig. 2 die Punkte a-k eingezeichnet. Es sei nun angenommen, daß das zusammengesetzte Übertragungssignal am Punkt a einen Pegel von 79 dBµV aufweist. Im variablen Dämpfungsglied VD₁ wird der Wert unabhängig vom Wert in Punkt a auf 74 dBµV geregelt (Punkt b). Das Pilotsignal weist am Punkt c einen Pegel von 100 dBµV bei einer Pilotfrequenz von ν = 80,15 MHz auf. Es wird in der Einkoppelvorrichtung PE₁ in das Übertragungssignal eingefügt. Aufgrund von Einfügedämpfungen weist das Übertragungssignal am Punkt d einen Pegel von 73 dBµV und das Pilotsignal einen Pegel von 69 dBµV auf. Im Breitbandverstärker BK₁ wird das Übertragungssignal und das Pilotsignal auf 90 dBµV bzw. 86 dBµV verstärkt, bevor es der Auskoppelvorrichtung RA₁ und dem Entzerrer EZ₁ zugeführt wird. Am Eingang des Vierfach-Splitters dem Punkt f betragen die Pegel noch 87, bzw. 83 dBµV, am Ausgang dem Punkt g nur noch 79, bzw. 75 dBµV.

Vorteil dieser Kanalamplitudenregelung ist, daß der Maximalpegel des Übertragungssignals in einer fest vorgegebenen Beziehung zum Pilotsignal steht. Hier im Ausführungsbeispiel ist eine konstante Differenz von 4 dB vorgesehen. Die Beziehung wird zunächst im Regler REG₁ eingestellt, der dann über das variable Dämpfungsglied VD₁ den Pegel des Übertragungssignals bestimmt. Als Maß für den Pegel des Übertragungssignals wird ein Signalteil als Referenzsignal verwendet, dessen Amplitude konstant und bekannt ist und ständig übertragen wird. Das Referenzsignal könnte ein eigens für die Regelung der Kanalamplitude vorgesehenes, in einen der zu übertragenden Kanäle eingespeistes Pilotsignal sein. Ist so ein Pilotsignal nicht vorhanden, wird vorteilhafterweise z.B. ein anderer geeigneterer Teil des Übertragungssignals, z.B. das frequenzmodulierte und somit eine konstante Amplitude aufweisende UKW-Band verwendet. Das Referenzsignal wird durch das Bandpaßfilder BF₁ als zur Regelung vorgesehenes Referenzsignal selektiert.

Zur Berücksichtigung des Umstandes, daß das Übertragungssignal eine unterschiedliche Anzahl von Übertragungskanäle enthalten kann und bei optimaler Ausnutzung der Bandbreite die Aussteuerung der Amplitude von der Anzahl der zu übertragenden Kanäle abhängt, wird das Übertragungssignal nach Durchlaufen der Kanalamplitudenregelung KAR₁ der Summenlastregelung SLR₁ zugeführt. Am Eingang der Summenlastregelung SLR₁ ist ein Breitbandverstärker BK₂ angeordnet, der den Pegel am Punkt g von 79 dBµV für das Übertragungssignal und 75 dBµV für das Pilotsignal auf die Werte 96 bzw. 92 dBµV in Punkt h erhöht. In der Summenlastregelung SLR₁ wird nun die Kanalbelegung, d.h. die Anzahl der im Übertragungssignal vorhandenen Kanäle berücksichtigt. Im Beispiel seien nun drei Fälle mit unterschiedlicher Anzahl von zu übertragenden Kanälen angenommen: Fall 1 10 Kanäle, Fall 2 25 Kanäle und Fall 3 30 Kanäle. Nach Durchlaufen des Breibandverstärkers BK₂ ergeben sich für alle drei Fälle die gleichen Werte 96 dBµV für das Übertragungssignal und 92 dBµV für das Pilotsignal. Da die zweite Rückkoppelschleife RKS₂ grundsätzlich wie die erste Rückkoppelschleife RKS₁ aufgebaut und auch gleichermaßen angeordnet ist, funktioniert sie auch grundsätzlich wie diese. Der Unterschied liegt nur darin, daß die zweite Rückkoppelschleife RKS₂ keinen Bandpaßfilter enthält, wodurch zur Regelung des variablen Dämpfungsgliedes VD₂ das gesamte Übertragungssignal, d.h. die Summe aller übertragenen Kanäle herangezogen wird. Entsprechend dämpft das variable Dämpfungsglied VD₂ das Übertragungssignal im Fall 3 stärker als im Fall 2 oder 1. Die Werte für das Übertragungssignal am Punkt i sind im Fall 1 86, im Fall 2 85 und im Fall 3 84 dBµV. Die Werte für das Pilotsignal liegen in allen drei Fällen um 4 dB niedriger. Am Ausgang der Summenlastregelung SLR₁ liegt zuletzt, nach einer nochmaligen Verstärkung der Signale im Punkt k für die Übertragungssignale im Fall 1 ein Pegel von 101 im Fall 2 von 100 und im Fall 3 von 99 dBµV an. Die Pegel der Pilotsignale liegen wiederum jeweils um 4 dB niedriger als die der Übertragungssignale.

Die automatische Amplitudenregelung AGC₁ erfüllt somit beide Anforderungen, Ausregeln von Regelschwankungen des Eingangssignals sowie die Erzielung eines konstanten Gesamtmodulationsgrades, wobei der Abstand des Pilotsignals zu den Übertragungskanälen jeweils konstant bleibt.

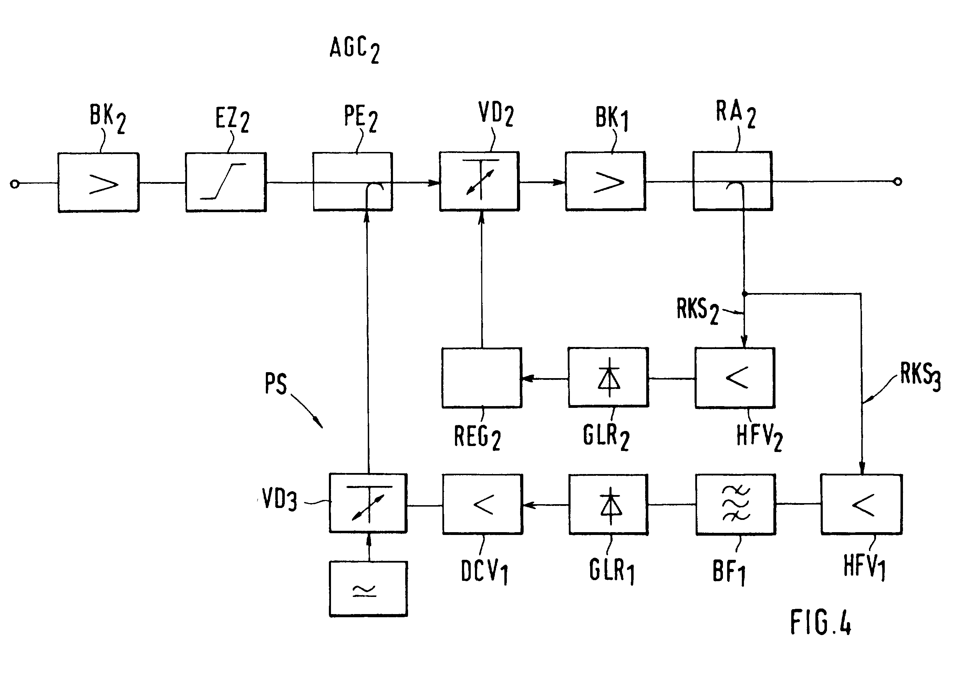

Ein zweites Ausführungsbeispiel einer automatischen Amplitudenregelung AGC₂ weist eine Summenlastregelung SLR₂ mit einer parallelen Pilotsteuerung PS als Kanalamplitudenregelung auf und ist in Fig. 4 abgebildet. Gleiche Elemente, wie sie schon im ersten Ausführungsbeispiel verwendet werden, sind mit den gleichen Bezugszeichen versehen. Ein Breitbandverstärker BK₂ stellt den Eingang für das Übertragungssignal dar. Er ist über einen Entzerrer EZ₂ mit einer Einkoppelvorrichtung PE₂ für das Pilotsignal verbunden. Die Einkoppelvorrichtung PE₂ ist auf ein variables Dämpfungsglied VD₂ geführt, das wiederum über einen ersten Breitbandverstärker BK₁ und einer Auskoppelvorrichtung RA₂ mit dem Ausgang der Schaltung verbunden ist. Über die Auskoppelvorrichtung RA₂ ist eine schmalbandige Rückkoppelschleife RKS₃ mit der Einkoppelvorrichtung PE₂ für das Pilotsignal verbunden. In der schmalbandigen Rückkoppelschleife RKS₃ ist die Pilotsteuerung PS enthalten. Die schmalbandige Rückkoppelschleife RKS₃ ist teilsweise, wie die schmalbandige Rückkoppelschleife RKS₁ zur Kanalamplitudenregelung des ersten Ausführungsbeispiels aufgebaut. Sie enthält einen Hochfrequenzverstärker HFV₁, ein diesem nachgeschalteten Bandpaßfilter BF₁, das über einen Gleichrichter GLR₁ und einen nachfolgenden Gleichstromverstärker DCV₁ auf den Steuereingang eines dritten variablen Dämpfungsgliedes VD₃ geführt ist. Am Signaleingang des variablen Dämpfungsgliedes VD₃ liegt ein konstantes Pilotsignal mit 100 dBµV an, das nun durch die schmalbandige Rückkoppelschleife RKS₃ gesteuert auf die Einkoppelungsvorrichtung PE₂ geführt ist.

Eine zweite Rückkoppelschleife RKS₂ ist von der Auskoppelvorrichtung RA₂ auf den Regeleingang des variablen Dämpfungsgliedes VD₂ geführt. Die zweite Rückkoppelschleife RKS₂ weist einen Hochfrequenzverstärker HFV₂, einen Gleichrichter GLR₂ und eine Regelvorrichtung REG₂ auf. Sie ist wie die zweite Rückkoppelschleife des ersten Ausfführungsbeispiels aufgebaut und stellt wie im ersten Ausführungsbeispiel einen Bestandteil der Summenlastregelung SLR₁ dar.

Zur Funktionsweise der automatischen Amplitudenanpassung AGC₂ wird hinsichtlich der Summenlastregelung wird auf das erste Ausführungsbeispiel verwiesen. Die als Pilotsteuerung PS ausgebildete Kanalamplitudenregelung erfüllt dieselbe Aufgabe wie die Kanalamplitudenregelung des ersten Ausführungsbeispiels, nämlich die Herstellung einer festen Beziehung zwischen einem Referenzsignal aus dem eingehenden Übertragungssignals mit einem in der automatischen Amplitudenanspassung eingespeisten Pilotsignal. Im ersten Ausführungsbeispiel wird das Pilotsignal konstant gehalten und das Referenzsignal auf eine vorgegebene Beziehung zum Pilotsignal geregelt. Im zweiten Ausführungsbeispiel erfolgt eine Pegelsteuerung des Pilotsignals in Abhängigkeit des Pegels des Referenzsignal unter Beibehaltung des Übertragungssignalpegels, z.B. derart, daß der ausgesteuerte Pegel des Referenzsignals 99 dBµV und der des Pilotsignals 95 dbµV zeigt. Dies entspricht dem gleichen, schon aus dem ersten Ausführungsbeispiel bekannten Abstand von 4 dB. Die tatsächliche Ausregelung von Amplitudenabweichungen des Eingangssignals übernimmt hier die Summenlastregelung über das variable Dampfungsglied VD₂.

In einem dritten Ausführungsbeispiel (ohne Abbildung) weist die automatische Amplitudenregelung AGC eine ähnliche Struktur wie im zweiten Ausführungsbeispiel auf. Der Unterschied liegt nun darin, daß die Pilotsteuerung PS keine schmalbandige Rückkoppelschleife RKS aufweist, sondern mit einem im Sender S befindlichen Mikroprozessor verbunden ist. Der Mikroprozessor ist hierzu auf der einen Seite mit einer zentralen Rechnereinheit der Kopfstation verbunden, die die Anzahl der zu übertragenden Kanäle kennt und diese Anzahl dem Mikroprozessor zuführt. Der Mikroprozessor steuert nun abhängig von der Anzahl der Kanäle den Pegel des Pilotsignals. Dies kann derart erfolgen, daß der Pilotpegel z.B. auf acht vorgegebene Stufen im Abstand von jeweils 1/2 oder 1/4 dBµV steuerbar ist. Da der Pilotpegel in Abhängigkeit der Kanalzahl gesteuert wird, ist die Piloteinkopplung PE₂ nach dem variablen Dämpfungsglied angeordnet.

Die auch in den Ausführungsbeispielen gezeigte Anordnung und Anzahl von Verstärkern, Entzerrern und Splittern erfolgt auf eine dem Fachmann für den einzelnen Anwendungsfall bekannten Art und Weise. Die verwendeten Komponenten können auch in einer anderen Reihenfolge oder Zusammensetzung angeordnet werden. So kann z.B. auf die Anordnung der Vierfachsplitter im ersten Ausführungsbeispiel verzichtet oder im zweiten Ausführungsbeispiel zwischen dem Entzerrer EZ₂ und der Einkoppelvorrichtung PE₂ ein Vierfach-Splitter angeordnet werden, was notwendigerweise eine andere Anordnung oder Dimensionierung der Breitbandverstärker zur Folge hat. Genauso können z.B. das Bandpaßfilter BS1 und der Hochfrequenzverstärker HFV₁ in umgekehrter Reihenfolge angeordnet sein. Die Erfindung wurde für ein optisches Kabelfernsehverteilsystem beschrieben. Sie ist ebenso für die Verwendung in Kabelfernsehverteilsystemen mit Koaxialkabeln oder auch für Kabelfernsehverteilsystemen mit Funkstrecken geeignet.

## Patentansprüche

1. Automatische Amplitudenregelung für einen Breitbandsender eines Fernsehverteilsystems, in der eine Vielzahl von Übertragungskanälen zu einem breitbandigen Übertragungssignal zusammengefaßt ist,
- mit einer Kanalamplitudenregelung (KAR₁), die eine Einkoppelvorrichtung zum Einfügen eines Pilotsignales in das Übertragungssignal aufweist und
- mit einer Summenlastregelung zur Erzielung eines konstanten Gesamtmodulationsgrades des Übertragungssignals,
**dadurch gekennzeichnet**, daß eine Vorrichtung (RKS₁, RKS₃) zur Selektion eines Referenzsignals mit repräsentativer Amplitude aus dem Übertragungssignal vorhanden ist, und daß eine Vorrichtung (VD₁; VD₂) vorhanden ist, die dieses Referenzsignal und das Pilotsignal in eine vorgegebene Beziehung bringt.

2. Automatische Amplitudenregelung nach Anspruch 1, dadurch gekennzeichnet, daß sich die Einkoppelvorrichtung (PE₁) für das Pilotsignal in der Kanalamplitudenregelung (KAR₁) befindet, die Kanalamplitudenregelung (KAR₁) ein variables Dämpfungsglied (VD₁) und eine schmalbandige Rückkoppelungsschleife (RKS₁) aufweist, über die das variable Dämpfungsglied (VD₁) geregelt ist, und dabei das Übertragungssignal über das variable Dämpfungsglied (VD₁) auf die Einkoppelvorrichtung (PE₁) für das Pilotsignal und auf die Auskoppelvorrichtung (RA₁) für die Rückkoppelschleife (RKS₁) geführt ist.

3. Automatische Amplitudenregelung nach Anspruch 1, dadurch gekennzeichnet, daß die Kanalamplitudenregelung (KAR₂) als Pilotpegelsteuerung (PS) ausgebildet ist, und daß der Einkoppelvorrichtung (PE₂) für das Pilotsignal eine Auskoppelvorrichtung (RA₂) für eine schmalbandige Rückkoppelungsschleife (RKS₃) nachgeschaltet ist, in der das Referenzsignal selektiert wird, mit dem die Amplitude des Pilotsignals über ein variables Dämpfungsglied (VD₃) gesteuert wird, und daß die Summenlastregelung (SLR₁) parallel zur Pilotsteuerung (PS) angeordnet ist.

4. Automatische Amplitudenregelung nach einer der Ansprüche 2 oder 3,
dadurch gekennzeichnet, daß die schmalbandige Rückkoppelschleife (RKS₁, RKS₃) einen Bandpaßfilter (BF₁) für Audiosignale aufweist.

5. Automatische Amplitudenregelung nach Anspruch 1, dadurch gekennzeichnet, daß die Summenlastregelung (SLR₁) ein variables Dämpfungsglied (VD₂), diesem nachfolgend einen Breitbandverstärker (BK₃) und eine Auskoppelungvorrichtung (RA₂) aufweist und das variable Dämpfungsglied (VD₂) über eine mit der Auskoppelvorrichtung (RA₂) verbundene Rückkoppelschleife (RKS₂) geregelt wird.

6. Automatische Amplitudenregelung für einen Breitbandsender eines Fernsehverteilsystems, in der eine Vielzahl von Übertragungskanälen zu einem breitbandigen Übertragungssignal zusammengefaßt ist,
- mit einer Kanalamplitudenregelung (KAR₁), die eine Einkoppelvorrichtung zum Einfügen eines Pilotsignales in das Übertragungssignal aufweist und
- mit einer Summenlastregelung zur Erzielung eines konstanten Gesamtmodulationsgrades des Übertragungssignals,
**dadurch gekennzeichnet**, daß sie eine Pilotsignalamplitudensteuerung aufweist und die Amplitude des Pilotsignals über ein variables Dämpfungsglied (VD₃) geregelt wird, wobei die Regelgröße eine von der Kanalbelegung abhängige Größe ist, die der Pilotsignalamplitudensteuerung (PS) über einen Rechner zuführbar ist.

7. Automatische Amplitudenregelung nach Anspruch 1 oder 6, dadurch gekennzeichnet, daß das Fernsehverteilsystem ein Kabelfernsehverteilsystem ist.

## Claims

1. Automatic gain control for a broadband transmitter of a television distribution system, wherein a multiplicity of transmission channels are combined into a broadband transmission signal, comprising
- a channel amplitude control (KAR₁) having a coupling device for inserting a pilot signal into the transmission signal and
- a sum load control for achieving a constant overall modulation depth of the transmission signal,
characterised in that a facility (RKS₁, RKS₃) is provided for selecting a reference signal having a representative amplitude from the transmission signal, and that a device (VD₁; VD₂) is provided which brings said reference signal and the pilot signal into a predetermined relationship.

2. Automatic gain control according to claim 1,
characterised in that the coupling device (PE₁) for the pilot signal is contained in the channel amplitude control (KAR₁), the channel amplitude control (KAR₁) comprises a variable attenuator (VD₁) and a narrow-band feedback loop (RKS₁) via which the variable attenuator (VD₁) is controlled, and at the same time the transmission signal is fed through the variable attenuator (VD₁) to the coupling device (PE₁) for the pilot signal and to the decoupling device (RA₁) for the feedback loop (RKS₁).

3. Automatic gain control according to claim 1,
characterised in that the channel amplitude control (KAR₂) is designed as a pilot level control (PS), and that the coupling device (PE₂) for the pilot signal is followed by a decoupling device (RA₂) for a narrow-band feedback loop (RKS₃), in which the reference signal is selected with which the amplitude of the pilot signal is controlled via a variable attenuator (VD₃), and that the sum load control (SLR₁) is connected in parallel with the pilot control (PS).

4. Automatic gain control according to one of claims 2 or 3, characterised in that the narrow-band feedback loop (RKS₁, RKS₃) comprises a bandpass filter (BF₁) for audio signals.

5. Automatic gain control according to claim 1, characterised in that the sum load control (SLR₁) comprises a variable attenuator (VD₂) followed by a broadband amplifier (BK₃) and a decoupling device (RA₂), and the variable attenuator (VD₂) is controlled via a feedback loop (RKS₂) connected to the decoupling device (RA₂) .

6. Automatic gain control for a broadband transmitter of a television distribution system, wherein a multiplicity of transmission channels are combined into a broadband transmission signal, comprising
- a channel amplitude control (KAR₁) having a coupling device for inserting a pilot signal into the transmission signal and
- a sum load control for achieving a constant overall modulation depth of the transmission signal,
characterised in that it comprises a pilot signal amplitude control and the amplitude of the pilot signal is controlled via a variable attenuator (VD₃), wherein the controlled variable is a variable dependent on the channel loading which can be fed to the pilot signal amplitude control (PS) via a computer.

7. Automatic gain control according to claim 1 or 6, characterised in that the television distribution system is a cable television distribution system.

## Revendications

1. Réglage automatique de l'amplitude pour un émetteur à large bande d'un système de répartition de télévision, dans lequel un grand nombre de canaux de transmission sont regroupés en un signal de transmission à large bande,
- avec un réglage d'amplitude de canal (KAR₁), qui présente un appareil de couplage pour l'insertion d'un signal pilote dans le signal de transmission et
- avec un réglage de charge globale pour obtenir un taux constant de modulation globale du signal de transmission,
caractérisé en ce qu'il existe un appareil (RKS₁, (RKS₃) pour sélectionner un signal de référence avec une amplitude représentative à partir du signal de transmission, et en ce qu'il existe un appareil (VD₁, VD₂), qui amène ce signal de référence et le signal pilote dans un rapport prédéfini.

2. Réglage automatique d'amplitude selon la revendication 1, caractérisé en ce que l'appareil de couplage (PE₁) pour le signal pilote se trouve dans le réglage de l'amplitude de canal (KAR₁), le réglage d'amplitude de canal (KAR₁) présente un atténuateur (VD) variable et une boucle de réaction (RKS₁) à bande étroite, par laquelle l'atténuateur (VD₁) variable est régulé, et le signal de transmission est guidé alors par l'atténuateur (VD₁) variable sur l'appareil de couplage (PE₁) pour le signal pilote et sur l'appareil de découplage (RA₁) pour la boucle de réaction (RKS₁).

3. Réglage d'amplitude automatique selon la revendication 1, caractérisé en ce que le réglage d'amplitude de canal (KAR₂) est conçu comme une commande de niveau pilote (PS), en ce qu'un appareil de découplage (RA₂) pour une boucle de réaction (RKS₃) à bande étroite est monté en aval de l'appareil de couplage (PF₂) pour le signal pilote, boucle dans laquelle on sélectionne le signal de référence, avec lequel l'amplitude du signal pilote est contrôlée par un atténuateur (VO₃) variable, et en ce que le réglage de charge totale (SLR₁) est disposé parallèlement à la commande pilote (PS).

4. Réglage d'ampiltude automatique selon l'une des revendications 2 ou 3, caractérisé en ce que la boucle de réaction à bande étroite (RKS₁, RKS₃) présente un filtre passe-bande (BF₁) pour les signaux audio.

5. Réglage d'amplitude automatique selon la revendication 1, caractérisé en ce que le réglage de charge totale (SLR₁) présente un atténuateur variable (VD₂), lui-même suivi d'un amplificateur à large bande (BK₃) et un appareil de découplage (RA₂) et l'atténuateur variable (VD₂) est régulé par une boucle de réaction (RKS₂) reliée à l'appareil de découplage (RA₂).

6. Réglage d'amplitude automatique pour un émetteur à large bande d'un système de répartition de télévision, dans lequel un grand nombre de canaux de transmission sont regroupés en un signal de transmission à large bande,
- avec un réglage d'amplitude de canal (KAR₁), qui présente un appareil de couplage pour l'insertion d'un signal pilote dans le signal de transmission et
- avec un réglage de charge totale pour obtenir un taux constant de modulation globale du signal de transmission, caractérisé en ce qu'il présente une commande d'amplitude du signal pilote et l'amplitude du signal pilote est régulée par un atténuateur variable (VD₃), la grandeur réglée étant une grandeur dépendante de l'occupation du canal, laquelle peut être amenée par un ordinateur à la commande d'amplitude du signal pilote (PS).

7. Réglage d'amplitude automatique selon la revendication 1 ou 6, caractérisé en ce que le système de répartition de télévision est un système de répartition de télévision par câble.
